# FASCICULE DE BREVET EUROPEEN

(11) **EP 2 995 850 B1**
(45) Date de publication et mention de la délivrance du brevet: **14.10.2020**
(21) Numéro de dépôt: 15184016.2
(22) Date de dépôt: 07.09.2015
(51) Int. Cl.: F21S 43/145, H01L 51/52, H05B 33/14, H05B 33/26, H05B 33/28, F21Y 105/00, F21S 41/663, F21S 43/19, F21Y 115/15, H05B 33/22

(54) **MODULE LUMINEUX MULTIFONCTION AVEC DIODE OLED SEGMENTEE**
MULTIFUNKTIONS-LEUCHTMODUL MIT SEGMENTIERTER OLED-DIODE
MULTIFUNCTIONAL LIGHT MODULE WITH SEGMENTED OLED DIODE

(30) Priorité: 15.09.2014 FR 1458666
(43) Date de publication de la demande: 16.03.2016
(73) Titulaire: VALEO VISION, 93012 Bobigny Cedex (FR)
(72) Inventeur: JIN, Hui, 75014 PARIS (FR); DUBOSC, Christophe, 93250 VILLEMOMBLE (FR); HUE, David, 95430 BUTRY SUR OISE (FR)

(56) Documents cités:
- WO-A1-2010/029459
- WO-A1-2011/107904
- WO-A1-2011/117771
- WO-A1-2013/168619
- DE-T5-112012 000 945
- US-A1- 2012 292 656
- US-A1- 2013 240 852

## Description

L'invention a trait au domaine de l'éclairage et/ou de la signalisation lumineuse, notamment pour véhicule automobile. Plus précisément, l'invention a trait au domaine de l'éclairage et de la signalisation lumineuse au moyen de diodes à électroluminescence (LED) et de diodes à électroluminescence organiques (OLED). Une diode OLED est constituée d'une superposition de plusieurs couches semi-conductrices organiques entre deux électrodes dont l'une est transparente. L'électrode transparente est habituellement réalisée en oxyde d'indium-étain (aussi connu sous l'acronyme ITO pour *Indium tin oxide*). La caractéristique principale de l'oxyde d'indium-étain est sa combinaison de conductivité électrique et de transparence optique. Cependant, un compromis doit être atteint lors du dépôt de films, l'augmentation de la concentration de porteurs de charges induisant une hausse de conductivité du matériau, mais aussi une perte de sa transparence. En d'autres termes, une électrode en ITO avec un bon niveau de transparence présente une conductivité limitée.

Les documents WO 2011/117771 A1 et US 2012/0292656 A1 décrivent des diodes organiques possédant des zones activables sélectivement définies par des portions d'électrodes électriquement isolées les unes des autres.

Le document de brevet publié WO 2009/101579 A1 divulgue un module lumineux comprenant une source lumineuse surfacique du type OLED et un dispositif optique. La source lumineuse OLED est segmentée de manière à pouvoir moduler le faisceau lumineux produit. A cet effet, elle comprend une anode fractionnée en deux portions électriquement indépendantes l'une de l'autre, et une cathode commune, une couche électroluminescente organique étant disposée entre l'anode et la cathode. Les raccordements électriques des deux portions de l'anode ainsi que de la cathode se font à des endroits différents du module, plus précisément à des bords opposés. Le module est en effet destiné à servir de module d'éclairage à monter sur ou dans une paroi. Dans ce cas de figure, la face arrière du module est en principe accessible pour y raccorder l'alimentation électrique. Une telle solution n'est cependant pas favorable à un montage en saillie d'un support du module ni à une réduction de l'épaisseur du module.

Le document de brevet DE 20 2014 101 538 U divulgue un module lumineux, notamment pour véhicule automobile, comprenant une source lumineuse surfacique du type OLED. Cette source lumineuse est fractionnée en plusieurs zones activables indépendamment l'une de l'autre. Pour ce faire, la diode surfacique est constituée d'un empilement d'électrodes, avec une couche électroluminescente organique entre chaque paire d'électrodes adjacentes. Chaque paire d'électrodes adjacentes peut ainsi servir d'anode et de cathode en vue de l'activation de la couche électroluminescente organique disposée entre cette paire d'électrodes. Cette construction de diode OLED est intéressante en ce qu'elle permet de produire plusieurs couleurs d'émission, en fonction du choix des matériaux des couches électroluminescentes organiques. Elle est cependant pénalisante par son coût de production ainsi que par les pertes potentielles de lumière produite par chaque paire d'électrode au travers des autres couches. Cet enseignement ne semble également pas aborder la question du raccordement électrique des électrodes en vue de leur alimentation.

Le document de brevet publié US 2014/0056020 A1 divulgue un module lumineux pour véhicule automobile, comprenant une série de sources lumineuses surfaciques du type OLED. Ces diodes OLED sont disposées de manière circulaire. En référence à la figure 4 et aux paragraphes [0034] et [0035] de ce document, un module lumineux généralement étendu peut comprendre plusieurs, en l'occurrence deux diodes OLED pouvant être activées indépendamment l'une de l'autre. Chacune de ces diodes OLED peut par ailleurs être fractionnée en plusieurs portions ou segments. Cet enseignement ne détaille cependant pas davantage le fractionnement d'une diode OLED en plusieurs segments.

L'invention a pour objectif de proposer une source lumineuse surfacique du type OLED palliant au moins un des inconvénients de l'état de l'art susmentionné. Plus particulièrement, l'invention a pour objectif de proposer une source lumineuse surfacique du type OLED apte à assurer plusieurs fonctions lumineuses dans des conditions favorables, notamment d'un point de vue optique, d'un point de vue montage sur un support et/ou d'un point de vue de l'encombrement selon l'épaisseur.

L'invention a pour objet une diode à électroluminescence organique telle que définie dans la revendication 1.

Avantageusement, les zones de connexion électrique sont destinées à l'alimentation électrique à la diode de façon à ce qu'au moins une portion de la diode émette de la lumière lorsque la diode est alimentée.

Avantageusement, les zones de connexion électrique sont situées sur un seul des bords de la diode.

Selon un mode avantageux de l'invention, la première électrode est reliée électriquement à au moins deux zones de connexion distinctes.

Selon un mode avantageux de l'invention, la première électrode, ou la portion, ou chacune des portions, de la deuxième électrode reliée(s) électriquement à au moins deux zones de connexion distinctes, est reliée à ses zones de connexion depuis des positions sur ladite électrode ou portion qui sont distantes l'une de l'autre d'au moins un quart, préférentiellement la moitié, de l'étendue maximale de ladite électrode ou portion.

Selon un mode avantageux de l'invention, la portion, ou chacune des portions, de la deuxième électrode qui contourne l'autre portion ou une des autres portions depuis le bord comprenant les zones de connexion électrique est reliée électriquement à deux zones de connexion distinctes disposées audit bord de part et d'autre d'au moins une zone de connexion reliée électriquement à l'autre ou une des autres portions qu'elle contourne.

Au moins une des portions, voire chaque portion, de la deuxième électrode est reliée électriquement à au moins deux zones de connexion distinctes disposées sur deux bords distincts, voire opposés, de la diode. Le cas échéant, ladite portion peut s'étendre sur tout le long de la diode. Dans ce cas, les portions de la deuxième électrode forment des bandes d'électrodes disposées de façon adjacente.

Selon un mode avantageux de l'invention, la première électrode et/ou au moins une des portions de la deuxième électrode comprend un conducteur électrique s'étendant le long de ladite électrode ou portion d'électrode, ledit conducteur étant en un matériau distinct et meilleur conducteur électrique que le matériau principal de la ladite électrode ou portion d'électrode.

Selon un mode avantageux de l'invention, le conducteur électrique de la première électrode et/ou de la portion ou des portions de la deuxième électrode s'étend jusqu'à la (aux) zone(s) de connexion électrique de ladite électrode ou portion d'électrode.

Selon un mode avantageux de l'invention, le conducteur électrique ou chacun des conducteurs électriques présente une largeur moyenne inférieure à 10 mm .

Selon un mode avantageux de l'invention, le matériau du ou des conducteurs électriques est de l'oxyde d'indium-étain (ITO) ou de l'aluminium ou du calcium. Selon un mode avantageux de l'invention, le conducteur électrique de la première électrode et/ou de la portion ou des portions de la deuxième électrode s'étend le long d'un contour de ladite électrode ou portion d'électrode.

Selon un mode avantageux de l'invention, la première électrode est réfléchissante et/ou la deuxième électrode est transparente.

Selon un mode avantageux de l'invention, la deuxième électrode est constituée d'oxyde d'indium-étain.

Selon un mode avantageux de l'invention, les zones de contact électrique sont situées, préférentiellement exclusivement, dans l'étendue de la diode sur une de ses deux faces principales.

L'invention a également pour objet un module lumineux, notamment pour véhicule automobile, comprenant : un support de source(s) lumineuse(s) ; au moins une source lumineuse surfacique du type diode à électroluminescence organique sur le support, apte à émettre un faisceau lumineux orienté essentiellement selon un axe optique dudit module ; remarquable en ce que la ou les sources lumineuses surfaciques sont conformes à l'invention, le faisceau lumineux étant modulable par activation sélective des portions de la deuxième électrode.

La source lumineuse surfacique peut être agencée pour que le faisceau lumineux réalise une première fonction photométrique, par exemple un feu de position, lors de l'activation d'une seule première portion de la deuxième électrode. La source lumineuse surfacique peut être agencée pour que le faisceau lumineux réalise une deuxième fonction photométrique, par exemple un clignotant, lors de l'activation d'une seule deuxième portion de la deuxième électrode. Eventuellement, la source lumineuse surfacique peut être agencée pour que le faisceau lumineux réalise une troisième fonction photométrique, par exemple un feu stop, lors de l'activation de toutes les portions de la deuxième électrode.

Selon un mode avantageux de l'invention, la ou les sources lumineuses surfaciques s'étendant transversalement à l'axe optique du module.

Selon un mode avantageux de l'invention, la ou les sources lumineuses surfaciques forment un angle α avec une direction perpendiculaire à l'axe optique qui est inférieur à 30°, préférentiellement 25°, plus préférentiellement 20°.

Selon un mode avantageux de l'invention, l'angle α est supérieur à 3°, préférentiellement 5°, plus préférentiellement 8°.

Selon un mode avantageux de l'invention, le faisceau lumineux émis par la ou les sources lumineuses surfaciques est un premier faisceau, le module comprenant une ou plusieurs sources lumineuses additionnelles apte à éclairer la ou les sources lumineuses surfaciques et à former un deuxième faisceau lumineux par réflexion sur lesdites sources lumineuses surfaciques.

Selon un mode avantageux de l'invention, le module comprend un dispositif optique, préférentiellement un collimateur, apte à dévier les rayons lumineux émis par la ou les sources lumineuses additionnelles selon une direction principale, lesdits rayons déviés rencontrant la ou les sources lumineuses surfaciques avec un angle d'incidence non nul.

Selon un mode avantageux de l'invention, le premier faisceau correspond à une fonction de signalisation de position pour véhicule automobile et/ou le deuxième faisceau correspond à une fonction de signalisation de freinage pour véhicule automobile.

Les mesures de l'invention sont intéressantes en ce qu'elles favorisent le montage de la source lumineuse en saillie d'un support. Elles sont également intéressantes en ce qu'elles favorisent l'homogénéité lumineuse en compensant les pertes par effet ohm le long des électrodes. La source lumineuse peut ainsi être utilisée comme émetteur de faisceau lumineux ainsi que comme réflecteur.

D'autres caractéristiques et avantages de la présente invention seront mieux compris à l'aide de la description et des dessins parmi lesquels :
- La figure 1 est une vue en perspective d'un module lumineux conforme à l'invention ;
- La figure 2 est une vue de face d'une des deux sources lumineuses surfaciques du type OLED du module de la figure 1 ;
- La figure 3 est une vue éclatée en perspective de la source lumineuse surfacique OLED de la figure 2 ;
- La figure 4 est une vue de face de la source lumineuse surfacique OLED de la figure 2, illustrant les zones de contact électrique ;
- La figure 5 est une vue de côté du module de la figure 1, illustrant la double fonction des sources lumineuses surfaciques du type OLED.

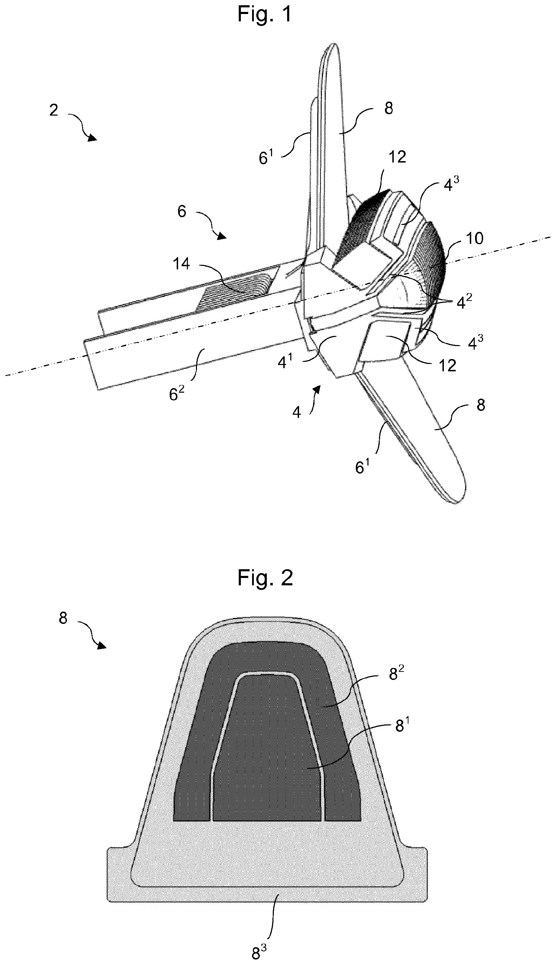

La figure 1 illustre un module de signalisation lumineuse pour véhicule automobile. Le module 2 est configuré pour être logé dans un boîtier disposé à l'arrière du véhicule. Il est configuré pour assurer une fonction de lanterne (ou feux arrière), une fonction de feux stop et une fonction d'indicateur de direction (ou clignotant).

Le module 2 comprend un substrat 4 et une pièce 6 rapportée sur le substrat. La pièce rapportée 6 peut être fixée au substrat au moyen de vis. Le substrat 4 comprend, essentiellement, une partie centrale 4¹, deux parois latérales 4², deux parois frontales 4³ faisant saillie des parois latérales 4². Les deux parois latérales 4² forment une cavité logeant des sources lumineuses (non visibles) ainsi qu'un collimateur 10 en vue de former un faisceau lumineux pour une fonction d'indicateur de direction.

La pièce rapportée 6 comprend deux supports 6¹ et une partie arrière 6². Les supports 6¹ sont disposés de manière à faire saillie de la partie centrale 4¹ du substrat 4 de manière essentiellement opposé l'un à l'autre. Chacun de ces supports 6¹ soutient une diode surfacique du type OLED 8. Une OLED est une diode à électroluminescence comprenant une superposition de plusieurs couches semi-conductrices organiques entre deux électrodes dont l'une (au moins) est transparente. En l'occurrence, ces diodes OLED assurent une fonction de lanterne. La partie arrière 6² de la pièce rapportée 6 est configurée pour loger un connecteur 14 d'alimentation électrique.

Le substrat 4 du module 2 supporte également une ou plusieurs sources lumineuses (non visibles) entre les parois latérales 4² et les diodes OLED 8, cette ou ces sources lumineuses étant recouvertes d'un collimateur 12 en vue d'assurer une fonction de feux stop. Plus précisément, les rayons émis par ces sources lumineuses et déviés par le collimateur 12 pour rencontrer la face avant de la diode OLED 8 correspondante et y être réfléchis vers l'avant du module.

L'axe longitudinal du module représenté aux figures 1 et 2 correspond à son axe optique. Cela signifie que les différents faisceaux lumineux produits par le module 2 sont orientés essentiellement selon cet axe. Tous ces faisceaux sont préférentiellement dirigés vers l'avant du module (correspondant à la droite à la figure 1 et à l'arrière du véhicule).

Les collimateurs 10 et 12 sont des pièces en matière transparente ou translucide, telle que du verre ou du polycarbonate (PC) ou du polyméthacrylate de méthyle (PMMA). Ils comprennent des surfaces d'entrée et ou de sorties orientées de manière à dévier les rayons selon une direction principale, en application du principe de réfraction de Snell-Descartes. Les faces d'entrée et de sortie forment en effet chacune un dioptre, à savoir une surface séparant deux milieux transparents homogènes et isotropes, d'indices de réfraction différents. L'indice de réfraction de l'air est en effet de l'ordre de 1 alors que celui du verre et du polycarbonate est situé entre 1.4 et 1.6 environ. Le principe de fonctionnement d'un collimateur est bien connu en soi de l'homme de métier ; il n'est par conséquent pas nécessaire de le détailler davantage.

La figure 2 illustre un exemple de diode surfacique OLED pour le module de la figure 1. On peut observer que la diode 8 est fractionnée en deux zones éclairantes, à savoir une première zone 8¹ et une deuxième zone 8². Chacune de ces zones peut être activée électriquement de manière indépendante.

Toujours à la figure 2, la diode 8 comprend un bord 8³ destiné à assurer la fixation et le raccordement électrique de la diode au support du module lumineux de la figure 1.

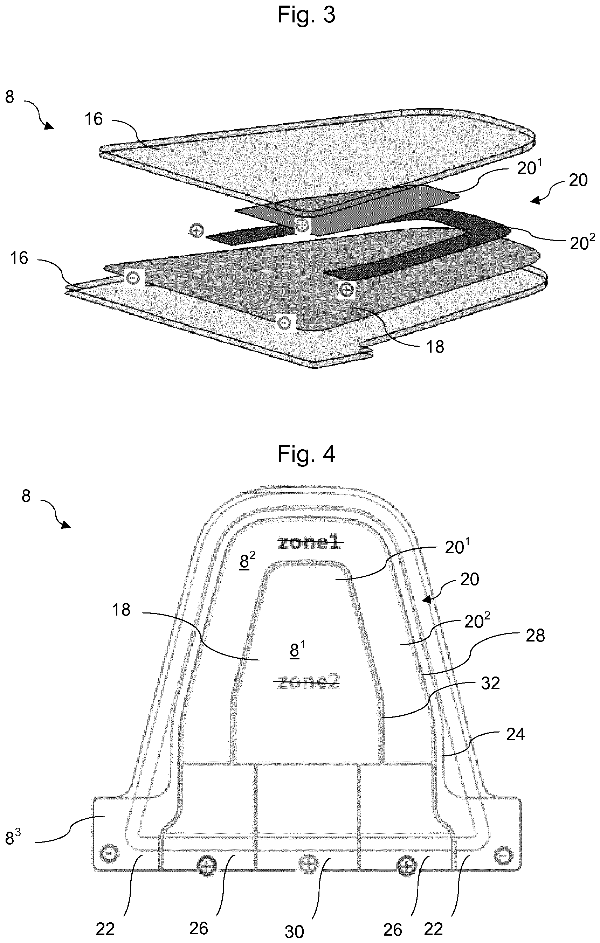

La figure 3 illustre en perspective et de manière éclatée la diode surfacique OLED 8 de la figure 2.

On peut observer que la diode 8 comprend deux couches extérieures 16 destinées à la protéger de l'extérieur. Ces couches sont transparentes et peuvent être notamment en verre. La diode 8 comprend également une première électrode 18 destinée à être raccordée à un potentiel négatif pouvant correspondre à la masse d'un véhicule (en cas de montage sur un véhicule). Cette première électrode est couramment appelée cathode. On peut observer que cette électrode 18 s'étend sur la majorité de l'étendue de la diode 8. Cette dernière comprend également une deuxième électrode 20 qui est fractionnée en plusieurs portions, en l'occurrence en deux portions 20¹ et 20². La portion 20¹ correspond à une portion centrale alors que la portion 20² contourne la portion centrale 20¹. Les portions 20¹ et 20² correspondent en fait, respectivement, aux première et deuxième zones 8¹ et 8² de la diode 8 telle qu'illustrée à la figure 2. La deuxième électrode 20, en l'occurrence ses deux portions 20¹ et 20², sont destinées à être amenées à un potentiel positif de manière à former un champ électrique avec la première électrode. La deuxième électrode est couramment appelée anode. A l'état assemblé de la diode, les deux anodes 20¹ et 20² sont essentiellement coplanaires, ou du moins alignées selon l'étendue de la diode au cas où la diode n'est pas plane.

Il est à mentionner que pour des raisons de clarté d'exposé, les couches électroluminescentes organiques n'y sont pas représentées. Ces couches sont en fait présentes entre les deux électrodes.

La cathode peut être réalisée en calcium ou encore en aluminium notamment lorsqu'elle est réfléchissante. Les anodes sont transparentes et peuvent être réalisées en oxyde d'indium-étain (aussi connu sous l'acronyme ITO pour *Indium tin oxide*). Ce matériau est connu pour présenter une transparence qui est inversement proportionnelle à sa conductivité.

La figure 4 est une vue de face de la diode 8 des figures 2 et 3, illustrant par transparence les zones de connexion électrique de la cathode et des anodes. On peut observer que les zones de connexion électrique sont situées sur le bord de montage 8³ de la diode 8. La cathode ou première électrode 18 n'est pas directement visible dans la mesure où elle est cachée par la deuxième électrode 20 (20¹ et 20²) qui lui est superposée. La cathode 18 est reliée électriquement aux deux zones de connexion électrique 22 situées aux extrémités du bord 8³. Plus particulièrement, un conducteur électrique 24 est directement relié électriquement aux zones de connexion 22 et s'étend le long du pourtour de la cathode 18 en vue d'assurer une distribution électrique optimale. Le matériau de la cathode peut en effet présenter une conductivité électrique limitée, si bien que la présence du conducteur le long de son pourtour est utile pour assurer un potentiel constant sur l'étendue de l'électrode. Le conducteur électrique est alors préférentiellement réalisé en un matériau métallique apte à assurer une conduction électrique optimale.

La première anode 20¹ est reliée électriquement avec la zone de connexion 30 qui est, en l'occurrence, située essentiellement au centre du bord 8³ de la diode. Similairement à la cathode, un conducteur électrique 32 sous forme d'une piste métallique peut s'étendre le long du pourtour de la première anode 20¹ et être reliée directement à la zone de connexion 30.

La deuxième anode 20² est reliée électriquement avec les deux zones de connexion 26 qui sont, en l'occurrence, situées de part et d'autre de la zone de connexion 30. Similairement à la cathode et à la première anode, un conducteur électrique 28 sous forme d'une piste métallique peut s'étendre le long du pourtour de la deuxième anode 20² et être relié directement aux deux zones de connexion 26.

Comme déjà mentionné précédemment, le matériau des anodes doit, d'une part, être transparent et, d'autre part, être conducteur. La ou les couches constituant les anodes doit/doivent rester suffisamment mince(s) pour rester transparente(s) et, partant, présenter une certaine résistivité qui est pénalisante pour l'homogénéité du faisceau lumineux émis par la diode. La présence du conducteur le long de l'étendue et/ou du pourtour des anodes est alors utile pour assurer un potentiel constant sur l'étendue de l'électrode.

Les zones de connexion électrique 22, 26 et 30 peuvent alors être contactées par des lamelles élastiques conductrices (non visibles) supportées par la pièce rapportée 6 du support du module de la figure 1.

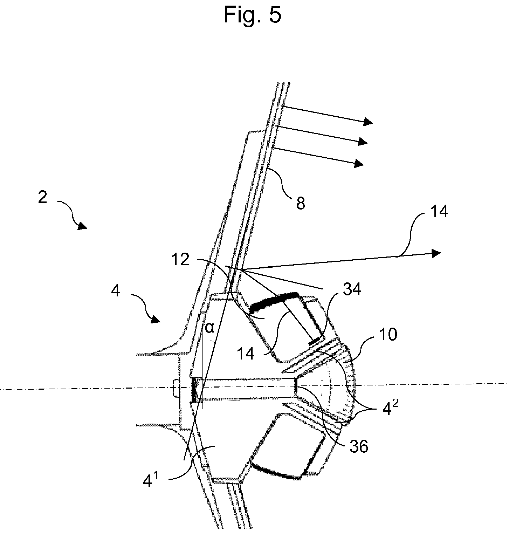

La figure 5 est une vue de côté de la partie centrale et supérieure du module lumineux de la figure 1. Le parcours d'un rayon 14 émis par une des diodes LED 34 éclairant une des diodes OLED y est représenté. Le rayon 14 est dévié une première fois lorsqu'il pénètre la matière transparente ou translucide du collimateur 12. Cette déviation n'est pas visible compte tenu de la proximité entre la diode 34 et la face d'entrée correspondante du collimateur 12. Le rayon se propage essentiellement en ligne droite dans la matière du collimateur jusqu'à ce qu'il atteigne la face de sortie, en l'occurrence un facette de sortie. Le rayon 14 est alors dévié une deuxième fois de manière à être dirigé vers une portion de la diode OLED 8 correspondante qui est proche de la portion centrale 4¹ du substrat 4. En d'autres termes, les rayons émis par les diodes 34 sont déviés par les collimateurs 12 de manière à rencontrer les diodes OLED 8 correspondantes en des zones desdites diodes qui sont proches de l'axe optique.

Comme mentionné précédemment, les diodes OLED 8 sont constituées d'une superposition de plusieurs couches semi-conductrices organiques entre deux électrodes dont l'une est transparente. En l'occurrence, l'électrode située à l'arrière est réfléchissante de manière à ce que, d'une part, la lumière émise par les couches semi-conductrices soit efficacement dirigée vers l'avant, et d'autre part, les rayons émis par les diodes LED 34 en direction des diodes OLED 8 soient réfléchis. L'électrode située à l'avant peut par conséquent être totalement ou du moins majoritairement transparente.

Les diodes OLED 8 forment avantageusement un angle α avec une direction perpendiculaire à l'axe optique du module, cet angle γ pouvant être compris entre 3° et 30°, préférentiellement entre 5° et 25°, plus préférentiellement entre 8° et 20°. Les diodes OLED 8 sont par ailleurs inclinées vers l'avant. L'angle α est supérieur à 0, préférentiellement à 3°, de manière à permettre la formation du faisceau lumineux correspondant au rayon 14. Cet angle est également limité de manière à ce que le faisceau lumineux produit par les rayons lumineux émis par les diodes OLED 8 ne soit pas trop divergent par rapport à l'axe optique.

Le faisceau lumineux produit par réflexion des rayons 14 des diodes LED 34 peut ainsi être produit indépendamment de l'activation des diodes OLED 8. En d'autres termes, le faisceau lumineux des diodes LED 34 peut s'additionner au faisceau lumineux produit

Le module qui vient d'être décrit peut ainsi assurer plusieurs fonctions de signalisation lumineuses. En l'occurrence, la partie centrale comprenant les diodes LED 36 et le collimateur 10 logés dans la cavité du substrat 4 peut assurer une fonction d'indicateur de direction (clignotant). Les diodes surfaciques OLED 8 peuvent assurer une fonction de signalisation de position (lanterne). Les diodes LED 34 avec les collimateurs 12 et la propriété de réflexion des diodes OLED 8 peuvent assurer une fonction d'indication de freinage (fonction stop). En effet, les exigences réglementaires en termes de photométrie sont plus élevées pour la fonction stop que pour la fonction de lanterne. La présence de plusieurs diodes 34, plus particulièrement de part et d'autre de l'axe optique, et la qualité de réflexion des diodes surfaciques 8 permet d'atteindre ces exigences.

## Revendications

1. Diode à électroluminescence organique (8) comprenant :
- une première électrode (18) généralement étendue ;
- une deuxième électrode (20) généralement étendue disposée en face de la première électrode (18), la deuxième électrode (20) comprenant au moins deux portions (20¹, 20²) électriquement isolées l'une de l'autre ;
- au moins une couche organique émettrice disposée entre les première et deuxième électrodes ;
- des zones de connexion électrique (22, 26, 30) des première et deuxième électrodes (18, 20) ;
- plusieurs bords ;
les zones de connexion électrique (22, 26, 30) des première et deuxième électrodes (18, 20) étant situées sur au moins l'un des bords (8³) de la diode **caractérisé en ce qu'**au moins une des portions (20²) de la deuxième électrode (20) est reliée électriquement à au moins deux zones de connexion (26) distinctes,
**en ce qu'**au moins une des portions (20²) de la deuxième électrode (20) contourne l'autre portion (20¹), ou une des autres portions, depuis le bord (8³) ou un des bords comprenant les zones de connexion électrique (22, 26, 30), et **en ce que** la portion (20²), ou chacune des portions, de la deuxième électrode (20) qui contourne l'autre portion (20¹) ou une des autres portions depuis le bord (8³) comprenant les zones de connexion électrique (22, 26, 30) est reliée électriquement à deux zones de connexion distinctes (26) disposées audit bord (8³) de part et d'autre d'au moins un zone de connexion (30) reliée électriquement à l'autre (20¹) ou une des autres portions qu'elle contourne.

2. Diode (8) selon la revendication 1, **caractérisée en ce que** la première électrode (18) est reliée électriquement à au moins deux zones de connexion distinctes (22).

3. Diode (8) selon l'une des revendications 1 à 2, **caractérisée en ce que** la première électrode (18) et/ou au moins une des portions (20¹, 20²) de la deuxième électrode (20) comprend un conducteur électrique (24, 32, 28) s'étendant le long de ladite électrode (18) ou portion d'électrode (20¹, 20²), ledit conducteur étant en un matériau distinct et meilleur conducteur électrique que le matériau principal de la ladite électrode ou portion d'électrode.

4. Diode (8) selon la revendication 3, **caractérisée en ce que** le conducteur électrique (24, 32, 28) de la première électrode (18) et/ou de la portion ou des portions (20¹, 20²) de la deuxième électrode (20) s'étend jusqu'à la (aux) zone(s) de contact électrique (24, 32, 28) de ladite électrode (18) ou portion(s) d'électrode (20¹, 20²).

5. Diode (8) selon l'une des revendications 3 ou 4, **caractérisée en ce que** le conducteur électrique (24, 32, 28) de la première électrode (18) et/ou de la portion ou des portions (20¹, 20²) de la deuxième électrode (20) s'étend le long d'un contour de ladite électrode (18) ou portion(s) d'électrode (20¹, 20²).

6. Diode (8) selon l'une des revendications 1 à 5, **caractérisée en ce que** la première électrode (18) est réfléchissante et/ou la deuxième électrode (20) est transparente.

7. Diode (8) selon l'une des revendications 1 à 6, **caractérisée en ce que** les zones de connexion électrique (22, 26, 30) sont situées, préférentiellement exclusivement, dans l'étendue de la diode (8) sur une de ses deux faces principales.

8. Module lumineux (2), notamment pour véhicule automobile, comprenant :
- un support (4, 6) de source(s) lumineuse(s) (8, 34, 36) ;
- au moins une source lumineuse surfacique (8) du type diode à électroluminescence organique sur le support, apte à émettre un faisceau lumineux orienté essentiellement selon un axe optique dudit module ;
**caractérisé en ce que**
la ou les sources lumineuses surfaciques (8) sont conformes à l'une des revendications 1 à 7, le faisceau lumineux étant modulable par activation sélective des portions de la deuxième électrode.

9. Module lumineux (2) selon la revendication 8, **caractérisé en ce que** la ou les sources lumineuses surfaciques (8) s'étendant transversalement à l'axe optique du module.

10. Module lumineux (2) selon l'une des revendications 8 ou 9, **caractérisé en ce que** le faisceau lumineux émis par la ou les sources lumineuses surfaciques (8) est un premier faisceau, le module (2) comprenant une ou plusieurs sources lumineuses additionnelles (34) apte à éclairer la ou les sources lumineuses surfaciques (8) et à former un deuxième faisceau lumineux par réflexion sur lesdites sources lumineuses surfaciques (8).

11. Module lumineux (2) selon la revendication 10, **caractérisé en ce qu'**il comprend un dispositif optique (12), préférentiellement un collimateur, apte à dévier les rayons lumineux émis par la ou les sources lumineuses additionnelles (34) selon une direction principale, lesdits rayons déviés rencontrant la ou les sources lumineuses surfaciques (8) avec un angle d'incidence non nul.

12. Module lumineux (2) selon l'une des revendications 10 ou 11, **caractérisé en ce que** le premier faisceau correspond à une fonction de signalisation de position pour véhicule automobile et/ou le deuxième faisceau correspond à une fonction de signalisation de freinage pour véhicule automobile.

## Patentansprüche

1. Organische Leuchtdiode (8), welche umfasst:
- eine im Wesentlichen ausgedehnte erste Elektrode (18) ;
- eine im Wesentlichen ausgedehnte zweite Elektrode (20), die gegenüber der ersten Elektrode (18) angeordnet ist, wobei die zweite Elektrode (20) wenigstens zwei Abschnitte (20¹, 20²) umfasst, die elektrisch isoliert voneinander sind;
- wenigstens eine emittierende organische Schicht, die zwischen der ersten und der zweiten Elektrode angeordnet ist;
- Bereiche der elektrischen Verbindung (22, 26, 30) der ersten und zweiten Elektrode (18, 20);
- mehrere Ränder;
wobei die Bereiche der elektrischen Verbindung (22, 26, 30) der ersten und zweiten Elektrode (18, 20) an mindestens einer der Ränder (8³) der Diode angeordnet sind,
**dadurch gekennzeichnet, dass** wenigstens einer der Abschnitte (20²) der zweiten Elektrode (20) mit wenigstens zwei verschiedenen Verbindungsbereichen (26) elektrisch verbunden ist,
dadurch, dass wenigstens einer der Abschnitte (20²) der zweiten Elektrode (20) um den anderen Abschnitt (20¹) oder einen der anderen Abschnitte vom Rand (8³) aus oder von einem der Ränder aus, welche die Bereiche der elektrischen Verbindung (22, 26, 30) umfassen, herumführt,
und dadurch, dass der Abschnitt (20²) oder jeder der Abschnitte der zweiten Elektrode (20), welcher um den anderen Abschnitt (20¹) oder einen der anderen Abschnitte von dem Rand (8³) aus, der die Bereiche der elektrischen Verbindung (22, 26, 30) umfasst, herumführt, mit zwei verschiedenen Verbindungsbereichen (26) elektrisch verbunden ist, die am Rand (8³) beiderseits wenigstens eines Verbindungsbereichs (30) angeordnet sind, der mit dem anderen (20¹) oder einem der anderen Abschnitte, um welche er herumführt, elektrisch verbunden ist.

2. Diode (8) nach Anspruch 1, **dadurch gekennzeichnet, dass** die erste Elektrode (18) mit wenigstens zwei verschiedenen Verbindungsbereichen (22) elektrisch verbunden ist.

3. Diode (8) nach einem der Ansprüche 1 bis 2, **dadurch gekennzeichnet, dass** die erste Elektrode (18) und/oder wenigstens einer der Abschnitte (20¹, 20²) der zweiten Elektrode (20) einen elektrischen Leiter (24, 32, 28) umfasst, der sich entlang der Elektrode (18) oder eines Elektrodenabschnitts (20¹, 20²) erstreckt, wobei der Leiter aus einem Material besteht, das von dem hauptsächlichen Material der Elektrode oder des Elektrodenabschnitts verschieden und ein besserer elektrischer Leiter als dieses ist.

4. Diode (8) nach Anspruch 3, **dadurch gekennzeichnet, dass** sich der elektrische Leiter (24, 32, 28) der ersten Elektrode (18) und/oder des Abschnitts oder der Abschnitte (20¹, 20²) der zweiten Elektrode (20) bis zu dem (den) Bereich(en) des elektrischen Kontakts (24, 32, 28) der Elektrode (18) oder des Elektrodenabschnitts (der Elektrodenabschnitte) (20¹, 20²) erstreckt.

5. Diode (8) nach einem der Ansprüche 3 oder 4, **dadurch gekennzeichnet, dass** sich der elektrische Leiter (24, 32, 28) der ersten Elektrode (18) und/oder des Abschnitts oder der Abschnitte (20¹, 20²) der zweiten Elektrode (20) entlang einer Kontur der Elektrode (18) oder des Elektrodenabschnitts (der Elektrodenabschnitte) (20¹, 20²) erstreckt.

6. Diode (8) nach einem der Ansprüche 1 bis 5, **dadurch gekennzeichnet, dass** die erste Elektrode (18) reflektierend ist und/oder die zweite Elektrode (20) transparent ist.

7. Diode (8) nach einem der Ansprüche 1 bis 6, **dadurch gekennzeichnet, dass** sich die Bereiche der elektrischen Verbindung (22, 26, 30), vorzugsweise ausschließlich, im Bereich der Diode (8) auf einer ihrer zwei Hauptflächen befinden.

8. Leuchtmodul (2), insbesondere für ein Kraftfahrzeug, welches umfasst:
- einen Träger (4, 6) einer Lichtquelle (von Lichtquellen) (8, 34, 36);
- wenigstens eine flächige Lichtquelle (8) vom Typ einer organischen Leuchtdiode auf dem Träger, die geeignet ist, ein Lichtbündel auszusenden, das im Wesentlichen entlang einer optischen Achse des Moduls ausgerichtet ist,
**dadurch gekennzeichnet, dass**
die flächige(n) Lichtquelle(n) (8) einem der Ansprüche 1 bis 7 entsprechen, wobei das Lichtbündel durch selektive Aktivierung der Abschnitte der zweiten Elektrode modulierbar ist.

9. Leuchtmodul (2) nach Anspruch 8, **dadurch gekennzeichnet, dass** sich die flächige(n) Lichtquelle(n) (8) quer zur optischen Achse des Moduls erstrecken.

10. Leuchtmodul (2) nach einem der Ansprüche 8 oder 9, **dadurch gekennzeichnet, dass** das Lichtbündel, das von der oder den flächigen Lichtquellen (8) ausgesendet wird, ein erstes Bündel ist, wobei das Modul (2) eine oder mehrere zusätzliche Lichtquellen (34) umfasst, die geeignet sind, die flächige(n) Lichtquelle(n) (8) zu beleuchten und ein zweites Lichtbündel durch Reflexion an den flächigen Lichtquellen (8) zu bilden.

11. Leuchtmodul (2) nach Anspruch 10, **dadurch gekennzeichnet, dass** es eine optische Vorrichtung (12), vorzugsweise einen Kollimator, umfasst, die geeignet ist, Lichtstrahlen, die von der oder den zusätzlichen Lichtquellen (34) in einer Hauptrichtung ausgesendet werden, abzulenken, wobei die abgelenkten Strahlen auf die flächige(n) Lichtquelle(n) (8) unter einem von null verschiedenen Einfallswinkel auftreffen.

12. Leuchtmodul (2) nach einem der Ansprüche 10 oder 11, **dadurch gekennzeichnet, dass** das erste Bündel einer Positionssignalisierungsfunktion für ein Kraftfahrzeug entspricht und/oder das zweite Bündel einer Bremssignalisierungsfunktion für ein Kraftfahrzeug entspricht.

## Claims

1. Organic light-emitting diode (8) comprising:
- a generally extensive first electrode (18);
- a generally extensive second electrode (20) placed facing the first electrode (18), the second electrode (20) comprising at least two portions (20¹, 20²) that are electrically insulated from each other;
- at least one emissive organic layer placed between the first and second electrodes;
- zones (22, 26, 30) for electrically connecting the first and second electrodes (18, 20); and
- a plurality of edges;
the zones (22, 26, 30) for electrically connecting the first and second electrodes (18, 20) being located on at least one of the edges (8³) of the diode;
**characterized in that** at least one of the portions (20²) of the second electrode (20) is electrically connected to at least two separate connecting zones (26); **in that** at least one of the portions (20²) of the second electrode (20) skirts around the other portion (20¹), or one of the other portions, from the edge (8³) or one of the edges comprising the electrically connecting zones (22, 26, 30); and **in that** the portion (20²), or each of the portions, of the second electrode (20) that skirts around the other portion (20¹) or one of the other portions from the edge (8³) comprising the electrically connecting zones (22, 26, 30) is electrically connected to two separate connecting zones (26) that are placed on said edge (8³) on either side of at least one connecting zone (30) electrically connected to the other (20¹) or one of the other portions that it skirts around.

2. Diode (8) according to Claim 1, **characterized in that** the first electrode (18) is electrically connected to at least two separate connecting zones (22).

3. Diode (8) according to one of Claims 1 to 2, **characterized in that** the first electrode (18) and/or at least one of the portions (20¹, 20²) of the second electrode (20) comprises an electrical conductor (24, 32, 28) extending along said electrode (18) or electrode portion (20¹, 20²), said conductor being made of a material different from and more highly electrically conductive than the main material of said electrode or electrode portion.

4. Diode (8) according to Claim 3, **characterized in that** the electrical conductor (24, 32, 28) of the first electrode (18) and/or of the portion or portions (20¹, 20²) of the second electrode (20) extends as far as the zone(s) of electrical contact (24, 32, 28) of said electrode (18) or electrode portion(s) (20¹, 20²).

5. Diode (8) according to one of Claims 3 or 4, **characterized in that** the electrical conductor (24, 32, 28) of the first electrode (18) and/or of the portion or portions (20¹, 20²) of the second electrode (20) extends along an outline of said electrode (18) or electrode portion(s) (20¹, 20²).

6. Diode (8) according to one of Claims 1 to 5, **characterized in that** the first electrode (18) is reflective and/or the second electrode (20) is transparent.

7. Diode (8) according to one of Claims 1 to 6, **characterized in that** the electrically connecting zones (22, 26, 30) are located, preferably exclusively, in the extent of the diode (8) on one of its two main faces.

8. Luminous module (2), especially for an automotive vehicle, comprising:
- a holder (4, 6) of one or more light sources (8, 34, 36); and
- at least one areal organic light-emitting diode light source (8) on the holder, able to emit a light beam oriented essentially along an optical axis of said module;
**characterized in that**
the one or more areal light sources (8) are according to one of Claims 1 to 7, the light beam being modulatable by selective activation of portions of the second electrode

9. Luminous module (2) according to Claim 8, **characterized in that** the one or more areal light sources (8) extend transversely to the optical axis of the module.

10. Luminous module (2) as claimed in one of Claims 8 or 9, **characterized in that** the light beam emitted by the one or more areal light sources (8) is a first beam, the module (2) comprising one or more additional light sources (34) able to illuminate the one or more areal light sources (8) and to form a second light beam by reflection from said areal light sources (8).

11. Luminous module (2) according to Claim 10, **characterized in that** it comprises an optical device (12), preferably a collimator, able to deviate the light rays emitted by the one or more additional light sources (34) in a main direction, said deviated rays encountering the one or more areal light sources (8) with a nonzero angle of incidence.

12. Luminous module (2) according to one of Claims 10 or 11, **characterized in that** the first beam corresponds to an automotive vehicle position signaling function and/or the second beam corresponds to an automotive vehicle braking signaling function.
